# EUROPEAN PATENT APPLICATION

(11) **EP 3 820 262 A1**
(43) Date of publication of application: **12.05.2021**
(21) Application number: 19207592.7
(22) Date of filing: 07.11.2019
(51) Int. Cl.: H05K 7/20, F28F 27/00, G01K 3/14, F28G 15/00, G01K 7/42, G01K 13/00

(54) **A METHOD FOR DETECTING A DISTURBANCE IN A LIQUID COOLING ARRANGEMENT FOR AN ELECTRIC APPARATUS**

(71) Applicant: ABB Schweiz AG, 5400 Baden (CH)
(72) Inventor: Salmia, Teemu, 00380 Helsinki (FI); Kärppä, Jaani, 00380 Helsinki (FI); Puukko, Joonas, 00380 Helsinki (FI)
(74) Representative: Kolster Oy Ab

(57) **Abstract**

The electric apparatus (300) comprises electric components (310, 320, 330) distributed on a bottom plate (200). The liquid cooling arrangement comprises a cooling plate (100) attached to the bottom plate, an interior of the cooling plate comprising at least one cooling channel for the cooling liquid. The method comprises measuring the temperature in several measuring points distributed over the bottom plate and/or the cooling plate and determining whether there is a disturbance in the liquid cooling in the cooling plate based on the measured temperatures.

## Description

### FIELD

The invention relates to a method for detecting a disturbance in a liquid cooling arrangement for an electric apparatus.

### BACKGROUND

The use of liquid cooling has become more frequent in electric apparatuses due to the increase in power densities. This means that a steadily increasing power loss must be removed from the electric apparatus in an efficient way. The use of liquid cooling is also the most effective solution in equipment requiring to be protected in accordance with a high IP-class (Ingress protection).

A liquid cooling is often realized with a structure in which a liquid is circulated within a cooling element having a high thermal conductivity. The liquid could in a simple solution be directed only into a single cooling channel within the cooling element. The use of a single cooling channel within the cooling element may not in all circumstances be an efficient and optimal solution. In order to reduce the pressure losses and in order to intensify the cooling effect, a channel system comprising several parallel cooling channels may instead be used.

The risk of reduced coolant flow in the cooling channel due to an accumulation of particles or due to an air pocket may occur in the cooling plate. This risk is even bigger in a cooling plate comprising several parallel cooling channels. A partial or total blocking of one or more cooling channels will result in a local degradation of the cooling of the cooling plate. A local degradation of the cooling of the cooling plate will result in an increase of the temperature of the component or components positioned in said area of the cooling plate suffering from reduced cooling. The temperature of the component or components in said area will increase whereby the life span of the component or components in said area decreases. The risk for a failure or a break-down of the component or components will also increase due to the increased operation temperature.

Electric apparatuses are often used in applications with a limited space such as in vehicles. The limited space means that small, light and power density components must to be used. The pump used for cooling in especially vehicle applications is often small and operates with a small voltage. The flow rate of the cooling liquid to the electric apparatus in the electric drive becomes thus restricted. The restricted flow rate of the cooling liquid combined with the requirement that the electric apparatus may be installed in any position will increase the risk of air pockets in the cooling liquid.

### SUMMARY

The invention relates to an improved method for detecting a disturbance in a liquid cooling arrangement for an electric apparatus.

The method according to the invention is defined in claim 1.

The electric apparatus comprises electric components distributed on a bottom plate, the liquid cooling arrangement comprising a cooling plate attached to the bottom plate of the electric apparatus, an interior of the cooling plate comprising at least one cooling channel for the cooling liquid.

The method comprises
measuring the temperature in several measuring points distributed over the bottom plate and/or the cooling plate,
determining whether there is a disturbance in the liquid cooling in the cooling plate based on the measured temperatures.

The method according to the invention may be used to detect disturbances such as air pockets in the cooling plate.

The method according to the invention does not require any additional hardware components to be installed. The temperature may be measured with thermistors which often are provided on the bottom plate and/or on the cooling plate in order to measure the temperature of the bottom plate and/or the cooling plate at the location of the thermistor. The thermistor may form a measuring point in the invention.

The resistance of a thermistor is proportional to the temperature of the thermistor. The thermistor may be an NTC thermistor or an PTC thermistor. The resistance of an NTC thermistor will decrease when the temperature of the NTC thermistor increases. The resistance of a PTC thermistor will increase when the temperature of the PTC thermistor increases.

In one embodiment of the invention, the temperature of each measuring point is compared with the temperature of the other measuring points or with a calculated temperature relating to said measuring point in order to determine a disturbance in the liquid cooling in the cooling plate.

In another embodiment of the invention, the temperature of each measuring point is compared with the temperature of the other measuring points in order to discover an abnormal temperature increase in one of the measuring points in relation to the other measuring points, whereby a temperature increase above a predetermined threshold in one of the measuring points in relation to the other measuring points indicates that there is a disturbance in the liquid cooling in the cooling plate at the measuring point with the increased temperature.

In still a further embodiment of the invention, the temperature of each measuring point is compared with a calculated temperature of said measuring point, the calculated temperature of the measuring point being determined based on the power losses of the electrical component relating to said measuring point in an operating point of the electrical component, whereby a difference between the calculated temperature and the measured temperature exceeding a predetermined threshold indicates that there is a problem in the liquid cooling in the cooling plate at said measuring point.

When a problem in the cooling has been discovered, then the flow rate of the cooling fluid could be raised temporarily until the differences in the temperatures have diminished under a desired threshold. When the problem e.g. the air pocket has been removed, then the flow rate of the cooling fluid may again be reduced to a normal level.

Air pockets do often develop in the cooling liquid when the system is taken into use and the cooling fluid system is filled. It is therefore important to be able to discover such a problem at an early stage in order to avoid break-down on the electric apparatus.

The method according to the invention will improve the reliability of the electric apparatus.

### DRAWINGS

The invention will be described with reference to the accompanying drawings in which
Figure 1 shows a schematic presentation of a liquid cooling arrangement,
Figure 2 shows a cross-sectional view of a liquid cooling arrangement,
Figure 3 shows a plan view of a liquid cooled cooling plate,
Figure 4 shows a schematic presentation of an electric power converter.

### DETAILED DESCRIPTION

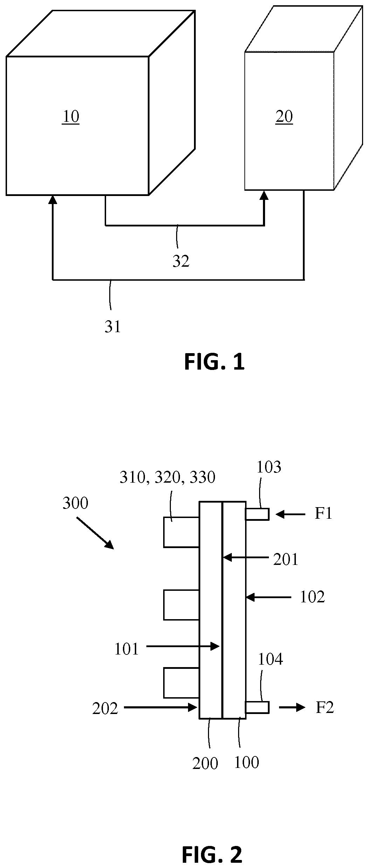

Figure 1 shows a schematic presentation of a liquid cooling arrangement.

The figure shows an electric module 10 and a heat exchanger or a liquid tank 20. An inlet conduit 31 and an outlet conduit 32 is connected between the electric module 10 and the heat exchanger 20. The electric module 10 may comprise comprising electric apparatuses e.g. one or more electric drives.

A cooling fluid is pumped from the heat exchanger 20 into the electric module 10 via the inlet conduit 31 in order to cool electric components within the electric module 10. The cooling fluid circulates within the electric module 10 in one or more cooling plates being in contact with the electric components within the electric module 10. The temperature of the cooling fluid increases as the cooling fluid passes through the one or more cooling plates within the electric module. The temperature increase of the cooling fluid is a result of the heat produced by the electric apparatuses in the electric module 10, said heat being transferred to the one or more cooling plates and thereby to the cooling fluid flowing in the one or more cooling plates.

Figure 2 shows a cross-sectional view of a liquid cooling arrangement.

The liquid cooling arrangement comprises a cooling plate 100 attached to a bottom plate 200.

The bottom plate 200 may comprise a bottom surface 201 and a top surface 202. An electric apparatus 300 may be provided on the top surface 202 of the bottom plate 200. The electric apparatus 300 may comprise electric components 310, 320, 330. The electric apparatus 300 may be an electric drive formed of an electric power converter. The electric power converter may comprise three phases. The electric components of the three phases of the electric power converter may be distributed on the bottom plate 200.

The cooling plate 100 may comprise a bottom surface 101 and a top surface 102. The bottom surface 101 of the cooling plate 100 may be attached to the bottom surface 201 of the bottom plate 200. The cooling plate 100 may further comprise an inlet 103 through which cooling liquid F1 may flow into the cooling plate 100 and an outlet 104 through which cooling liquid F2 may flow out from the cooling plate 100. The cooling plate 100 may be made of a material having a good thermal conductivity. The heat generated by the electric equipment 310, 320, 330 on the bottom plate 200 should be transferred to the cooling plate 100 and further to the cooling liquid flowing in the cooling plate 100. The cooling fluid may flow through several parallel cooling channels within the cooling plate 100.

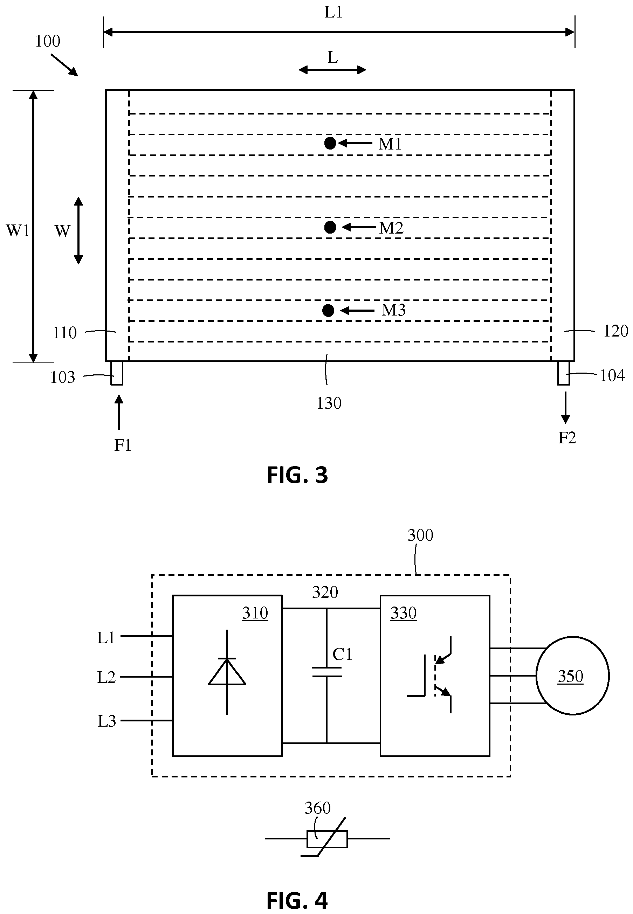

Figure 3 shows a plan view of a liquid cooled cooling plate.

The cooling plate 100 may comprise an inlet 103 and an outlet 104. The interior of the cooling plate 100 may comprise an inlet channel 110, an outlet channel 120 and one or more cooling channels 130 connecting the inlet channel 110 and the outlet channel 120. The inlet channel 110 may extend at a first end of the cooling plate 100 in a width direction W across a width W1 of the cooling plate 100. The outlet channel 120 may extend at an opposite second end of the cooling plate 100 in the width direction W across the width W1 of the cooling plate 100. The parallel cooling channels 130 extend in a length direction L across a length L1 of the cooling plate 100 between the inlet channel 110 and the outlet channel 120. A first end of the parallel cooling channels 130 open into the inlet channel 110 and a second opposite end of the parallel cooling channels 130 open into the outlet channel 120.

Cooling fluid F1 may flow from a heat exchanger via the inlet 103 of the cooling plate 100 to the inlet channel 110 at the first end of the cooling plate 100. The cooling fluid is distributed from the inlet channel 110 to the parallel cooling channels 130. The cooling fluid flows then in the parallel cooling channels 130 from the inlet channel 110 at the first end of the cooling plate 100 to the outlet channel 120 at the second end of the cooling plate 100. The cooling fluid flows then from the outlet channel 120 to the outlet 104. The outlet 104 may be connected to the heat exchanger.

The components 310, 320, 330 of the electric apparatus 300 may be distributed on the bottom plate 200 which is attached to the cooling plate 100. The distribution of the components 310, 320, 330 of the electric apparatus 300 on the cooling plate 100 will be the same as the distribution of the components 310, 320, 330 of the electrical apparatus 300 on the bottom plate 200. The components 310, 320, 330 of the electric apparatus 300 are thus distributed in the longitudinal direction L and in the width direction W over the bottom plate 200 and over the cooling plate 100.

The figure shows three temperature measuring points M1, M2, M3 distributed on the bottom plate 200 and/or the cooling plate 100. The measuring points M1, M2, M3 may be physically provided either on the bottom plate 200 or on the cooling plate 100 or on both. Each measuring point M1, M2, M3 may be positioned in connection with a phase in the electric power converter. Each measuring point M1, M2, M3 may be provided with a thermistor for measuring the temperature in said measuring point M1, M2, M3.

A thermistor is a type of resistor whose resistance is dependent on the temperature to a greater degree than a normal resistor. An NTC thermistor has a negative temperature coefficient i.e. the resistance of the NTC thermistor decreases when the temperature of the NTC thermistor increases. A PTC thermistor has a positive temperature coefficient i.e. the resistance of the PTC thermistor increases when the temperature of the PTC thermistor increases.

Figure 4 shows a schematic presentation of an electric power converter.

The electric power converter 300 may comprise a rectifier 310 transforming a three phase AC current into a DC current, an intermediate circuit 320 for smoothing the DC current and an inverter 330 for converting the DC current into a three phase AC current. The rectifier 310 may be based on a diode bridge, the intermediate circuit 320 may be based on capacitances C1, and the inverter 330 may be based on IGBT-switches (Insulated-Gate Bipolar Transistor). The electric power converter 300 may supply electric power to an electric motor 350.

A thermistor 360 may be positioned in connection with each phase L1, L2, L3 of the electric power converter 300. The figure shows only one thermistor 360 schematically in connection with the electric power converter 300.

The three phases L1, L2, L3 of the electric power converter 300 may be distributed over the bottom plate 200 so that the phases are adjacent to each other on the bottom plate 200. The position of the phases will be reflected in the same way on the cooling plate 100. The thermistors 360 may also be distributed in a corresponding way over the bottom plate 200. Each thermistor 360 will thus measure the temperature of a corresponding portion of the bottom plate 200.

The thermistors 360 are normally positioned on the bottom plate 200. The thermistors 360 could, however, as an alternative be positioned on the cooling plate 100. The thermistors 360 could as a further alternative be positioned on the bottom plate 200 and on the cooling plate 100.

Further thermistors could be arranged in connection with the inlet channel 110 and/or the outlet channel 120 in the cooling plate 100.

The bottom plate 200 and thereby also the cooling plate 100 may be arranged in any position on the installation site of the electric apparatus. The problem of air pockets may thus be present also in cooling plates 100 comprising a single cooling channel.

The invention and its embodiments are not limited to the examples shown in the figures, but the invention may vary within the scope of the protection defined by the claims.

## Claims

1. A method for detecting a disturbance in a liquid cooling arrangement for an electric apparatus, the electric apparatus (300) comprising electric components (310, 320, 330) distributed on a bottom plate (200), the liquid cooling arrangement comprising a cooling plate (100) attached to the bottom plate (200) of the electric apparatus (300), an interior of the cooling plate (100) comprising at least one cooling channel (130) for the cooling liquid,
the method comprising
measuring the temperature in several measuring points (M1, M2, M3) distributed over the bottom plate (200) and/or the cooling plate (100),
determining whether there is a disturbance in the liquid cooling in the cooling plate (100) based on the measured temperatures.

2. The method according to claim 1, wherein the temperature of each measuring point (M1, M2, M3) is compared with the temperature of the other measuring points (M1, M2, M3) or with a calculated temperature relating to said measuring point (M1, M2, M3) in order to determine a disturbance in the liquid cooling in the cooling plate (100).

3. The method according to claim 1 or 2, wherein the temperature of each measuring point (M1, M2, M3) is compared with the temperature of the other measuring points (M1, M2, M3) in order to discover an abnormal temperature increase in one of the measuring points (M1, M2, M3) in relation to the other measuring points (M1, M2, M3), whereby a temperature increase above a predetermined threshold in one of the measuring points (M1, M2, M3) in relation to the other measuring points (M1, M2, M3) indicates that there is a disturbance in the liquid cooling in the cooling plate (100) at the measuring point (M1, M2, M3) with the increased temperature.

4. The method according to claim 1 or 2, wherein the temperature of each measuring point (M1, M2, M3) is compared with a calculated temperature of said measuring point (M1, M2, M3), the calculated temperature of the measuring point (M1, M2, M3) being determined based on the power losses of the electrical component (310, 320, 330) relating to said measuring point (M1, M2, M3) in an operating point of the electrical component (310, 320, 330), whereby a difference between the calculated temperature and the measured temperature exceeding a predetermined threshold indicates that there is a problem in the liquid cooling in the cooling plate (100) at the position of said measuring point (M1, M2, M3).

5. The method according to any one of claims 1 to 4, wherein the temperature in each measuring point (M1, M2, M3) is measured with a thermistor (360).

6. The method according to any one of claims 1 to 5, wherein the interior of the cooling plate (100) comprises several parallel cooling channels (130).

7. The method according to any one of claims 1 to 6, wherein the electric apparatus (300) is an electric drive comprising a power converter (300) for driving an electric motor (350).

8. The method according to claim 7, wherein the measuring points (M1, M2, M3) are arranged on the bottom plate (200) in connection with each phase (L1, L2, L3) in the power converter (300).
